# EUROPÄISCHE PATENTSCHRIFT

(11) **EP 3 066 907 B1**
(45) Veröffentlichungstag und Bekanntmachung des Hinweises auf die Patenterteilung: **01.03.2017**
(21) Anmeldenummer: 15788443.8
(22) Anmeldetag: 04.11.2015
(51) Int. Cl.: H05K 7/14, F16B 5/06

(54) **BEFESTIGUNGSELEMENT ZUR BEFESTIGUNG AN EINER LEITERPLATTE SOWIE BEFESTIGUNGSVORRICHTUNG UND VERFAHREN ZUM BEABSTANDETEN VERBINDEN VON LEITERPLATTEN MIT EINEM DERARTIGEN BEFESTIGUNGSELEMENT**
SECURING ELEMENT FOR SECURING TO A PRINTED CIRCUIT BOARD, AND SECURING APPARATUS AND METHOD FOR SPACED CONNECTION OF PRINTED CIRCUIT BOARDS USING SUCH A SECURING ELEMENT
ÉLÉMENT DE FIXATION POUR LA FIXATION SUR UNE PLAQUE DE CIRCUIT IMPRIMÉ AINSI QUE DISPOSITIF DE FIXATION ET PROCÉDÉ POUR LA LIAISON AVEC ÉCARTEMENT DE PLAQUES DE CIRCUIT IMPRIMÉ AVEC UN ÉLÉMENT DE FIXATION DE CE GENRE

(30) Priorität: 11.11.2014 DE 102014222951
(43) Veröffentlichungstag der Anmeldung: 14.09.2016
(73) Patentinhaber: Würth Elektronik eiSos GmbH & Co. KG, 74638 Waldenburg (DE)
(72) Erfinder: BRODBECK, Micha, 74535 Ammertsweiler (DE); KLINGLER, Stefan, 74544 Michelbach (DE); KÜBLER, Daniel, 71560 Sulzbach / Murr (DE)
(74) Vertreter: Rau, Schneck & Hübner Patentanwälte Rechtsanwälte PartGmbB
(86) Internationale Anmeldenummer: PCT/EP2015/075713
(87) Internationale Veröffentlichungsnummer: WO 2016/075012

(56) Entgegenhaltungen:
- EP-A2- 2 254 398
- DE-U1- 8 631 156
- US-A1- 2005 217 088
- US-A1- 2013 141 852

## Beschreibung

Die vorliegende Patentanmeldung nimmt die Priorität der deutschen Patentanmeldung DE 10 2014 222 951.0 in Anspruch, deren Inhalt durch Bezugnahme hierin aufgenommen wird.

Die Erfindung betrifft ein Befestigungselement zur Befestigung an einer Leiterplatte. Ferner betrifft die Erfindung eine Befestigungsvorrichtung sowie ein Verfahren zum beabstandeten Verbinden von Leiterplatten mit einem derartigen Befestigungselement.

Aus der DE 86 31 156 U1 ist eine Befestigungsvorrichtung mit einem Abstandsrohr und einer Distanzhülse bekannt. Das Abstandsrohr bildet Anschläge für eine Leiterplatte und die Distanzhülse aus. Mittels einer Schraube werden die Leiterplatte, das Abstandsrohr und die Distanzhülse miteinander verbunden.

Aus der DE 10 2007 035 794 A1 ist ein Leiterplattenverbund bekannt, bei dem eine erste Leiterplatte mittels Abstandshaltern elektrisch leitend mit einer zweiten Leiterplatte verbunden ist. In die Abstandshalter aus Kunststoff sind Kontaktpins eingegossen. Ein umgebogener Kontaktpin wird mittels Lötmittel elektrisch leitend an der ersten Leiterplatte festgelegt, wohingegen ein zweiter Kontaktpin durch eine Montageöffnung in der zweiten Leiterplatte geführt und dort mit Hilfe von Lötmittel verlötet wird. Nachteilig ist, dass die Herstellung des Leiterplattenverbunds aufwendig ist und insbesondere keine elektrisch isolierende Verbindung herstellbar ist.

Aus der EP 0 357 362 A2 ist ein Gehäuse für elektronische Bauteile bekannt. In dem Gehäuse ist eine Basisplatte angeordnet, die erhabene Bereiche zur Befestigung einer Leiterplatte aufweist. Zur Befestigung dienen Befestigungselemente, die mit den erhabenen Bereichen und der Leiterplatte verrastet sind.

Der Erfindung liegt somit die Aufgabe zugrunde, ein Befestigungselement zu schaffen, das in einfacher Weise eine automatisierte Montage an einer Leiterplatte ermöglicht. Das Befestigungselement soll insbesondere eine elektrisch isolierende Verbindung zwischen Leiterplatten ermöglichen.

Diese Aufgabe wird durch ein Befestigungselement mit den Merkmalen des Anspruchs 1 gelöst. Mittels des ersten Befestigungsabschnitts kann das Befestigungselement in einfacher und automatisierter Weise mit einem Abstandselement verbunden werden, das zur Befestigung an einer ersten Leiterplatte dient. Weiterhin kann das Befestigungselement mittels des zweiten Rastabschnitts in einfacher und automatisierter Weise mit einer zweiten Leiterplatte verrastet werden, so dass die Leiterplatten beabstandet miteinander verbunden sind. Der zwischen dem Befestigungsabschnitt und dem Rastabschnitt angeordnete Mittelabschnitt dient zur Ausbildung eines ersten Anschlags für das Verbinden des ersten Befestigungsabschnitts mit dem zugehörigen Abstandselement sowie zur Ausbildung eines zweiten Anschlags für das Verbinden bzw. Verrasten und/oder die Aufnahme der zweiten Leiterplatte an dem zweiten Rastabschnitt. Das Befestigungselement ist zur Ausbildung des Befestigungsabschnitts und des Rastabschnitts insbesondere aus einem elastischen Material hergestellt, wie beispielsweise einem Kunststoffmaterial.

Die Montagefläche gewährleistet in einfacher Weise eine automatisierte Montage des Befestigungselements. Durch die endseitig an dem zweiten Rastabschnitt angeordnete Montagefläche kann das Befestigungselement in einfacher Weise automatisiert gehalten und montiert werden. Beispielsweise kann das Befestigungselement automatisiert mit dem zugehörigen Abstandselement verbunden werden. Darüber hinaus kann das Befestigungselement mit dem damit verbundenen Abstandselement automatisiert gehalten werden, um das Abstandselement in einfacher und automatisierter Weise mit der ersten Leiterplatte zu verbinden. Die Montagefläche dient als Ansaugfläche, um das Befestigungselement pneumatisch zu halten.

Ein Befestigungselement nach Anspruch 2 gewährleistet eine einfache automatisierte Montage. Durch die eben ausgebildete Montagefläche kann das Befestigungselement in einfacher Weise gehalten werden. Dies erfolgt pneumatisch. Für die Montagefläche A gilt insbesondere:
A ≥ 3 mm², insbesondere A ≥ 4,5 mm², und insbesondere A ≥ 6 mm². Die Montagefläche ist vorzugsweise kreisförmig ausgebildet. Vorzugsweise verläuft die Montagefläche senkrecht zu einer Mittellängsachse des Befestigungselements. Hierdurch wird in einfacher Weise eine Bewegung des Befestigungselements zum Verbinden mit dem Abstandselement und/oder zum Befestigen des Abstandselements an der ersten Leiterplatte in Richtung der Mittellängsachse ermöglicht.

Ein Befestigungselement nach Anspruch 3 ermöglicht auf einfache Weise ein Verrasten des zweiten Rastabschnitts mit einer zweiten Leiterplatte. Dadurch, dass der zweite Rastabschnitt im Bereich der Montagefläche eine Solldeformationsstelle, insbesondere eine Sollbruchstelle aufweist, wird ein einfaches Einführen des zweiten Rastabschnitts in eine zugehörige Ausnehmung an der zweiten Leiterplatte ermöglicht. Da die Montagefläche beim Verrasten des zweiten Rastabschnitts mit einer zweiten Leiterplatte nicht mehr benötigt wird, ist eine Deformation bzw. ein Bruch der Montagefläche nicht nachteilig.

Ein Befestigungselement nach Anspruch 4 gewährleistet auf einfache Weise ein Verrasten des zweiten Rastabschnitts mit einer zweiten Leiterplatte. Dadurch, dass die mindestens zwei Rastarme endseitig durch eine Wand verbunden sind, bildet der zweite Rastabschnitt einerseits eine Montagefläche aus. Andererseits sind die mindestens zwei zueinander beabstandeten Rastarme aufgrund der Solldeformationsstelle, insbesondere der Sollbruchstelle in einfacher Weise radial zu einer Mittellängsachse des Befestigungselements verlagerbar. Da die Rastarme flexibel verlagerbar sind, wird in einfacher Weise ein Verrasten des zweiten Rastabschnitts mit einer zweiten Leiterplatte ermöglicht. Vorzugsweise sind die mindestens zwei Rastarme aus einem Kunststoffmaterial ausgebildet.

Ein Befestigungselement nach Anspruch 5 gewährleistet in einfacher Weise ein Verrasten des als ersten Rastabschnitts ausgebildeten Befestigungsabschnitts mit einem Abstandselement. Der mindestens eine erste Rastvorsprung erstreckt sich in radialer Richtung ausgehend von dem Tragzapfen. Beispielsweise ist der mindestens eine erste Rastvorsprung lamellen-, gewinde- und/oder tellerartig ausgebildet.

Ein Befestigungselement nach Anspruch 6 gewährleistet in einfacher Weise eine sichere Befestigung des Befestigungselements an dem zugehörigen Abstandselement.

Ein Befestigungselement nach Anspruch 7 gewährleistet ein einfaches automatisiertes Verbinden des Befestigungselements mit dem zugehörigen Abstandselement. Dadurch, dass sich der Befestigungsabschnitt zu seinem freien Ende verjüngt, kann dieser einfach und sicher in eine zugehörige Ausnehmung des Abstandselements eingeführt werden.

Ein Befestigungselement nach Anspruch 8 gewährleistet eine einfache automatisierte Befestigung einer zweiten Leiterplatte an dem zweiten Rastabschnitt. Dadurch, dass sich der mindestens eine zweite Rastvorsprung in Richtung eines freien Endes verjüngt, kann der zweite Rastabschnitt einfach und sicher in eine zugehörige Ausnehmung der zweiten Leiterplatte eingeführt werden.

Ein Befestigungselement nach Anspruch 9 gewährleistet eine einfache und automatisierte Verbindung mit einer ersten Leiterplatte. Ein mit dem Befestigungselement verbundenes Abstandselement wird vorzugsweise mit einer ersten Leiterplatte verlötet. Hierdurch weist das Abstandselement eine hohe Temperatur auf. Da das Abstandselement in Kontakt mit dem Befestigungselement ist, wird auch das Befestigungselement mit einer hohen Temperatur beaufschlagt. Das temperaturbeständige Kunststoffmaterial verhindert eine Beschädigung des Befestigungselements. Temperaturbeständig bedeutet insbesondere, dass bis zu einer Mindesttemperatur keine Erweichung des Kunststoffmaterials stattfindet. Das Befestigungselement ist vorzugsweise aus einem Hochtemperatur-Kunststoffmaterial, wie beispielsweise LCP (LCP: Liquid Crystal Polymer) ausgebildet.

Ein Befestigungselement nach Anspruch 10 ermöglicht eine elektrisch isolierende Verbindung zwischen zwei Leiterplatten.

Ein Befestigungselement nach Anspruch 11 gewährleistet in einfacher Weise eine zuverlässige Befestigung. Das Befestigungselement ist zudem einfach herstellbar. Der Befestigungsabschnitt und/oder der Rastaschnitt sind insbesondere derart ausgebildet, dass die zugehörige Verbindung mit dem Abstandselement bzw. der Leiterplatte fest oder wieder lösbar ist. Der Erfindung liegt ferner die Aufgabe zugrunde, eine Befestigungsvorrichtung zu schaffen, die auf einfache, flexible und automatisierte Weise ein beabstandetes Verbinden von Leiterplatten ermöglicht.

Diese Aufgabe wird durch eine Befestigungsvorrichtung mit den Merkmalen des Anspruchs 12 gelöst. Die Vorteile der erfindungsgemäßen Befestigungsvorrichtung entsprechen den bereits beschriebenen Vorteilen des erfindungsgemäßen Befestigungselements. Der erste Befestigungsabschnitt des Befestigungselements ist mit dem Abstandselement verbunden. Die Verbindung zwischen dem Befestigungsabschnitt und dem Abstandselement kann formschlüssig, kraftschlüssig und/oder stoffschlüssig ausgebildet sein. Beispielsweise kann die Verbindung als Rastverbindung, Schraubverbindung, Verbindung, Klebverbindung und/oder Spritzgussverbindung ausgebildet sein. Der Befestigungsabschnitt ist vorzugsweise in einer Ausnehmung des Abstandselements angeordnet und darin befestigt. Die Ausnehmung ist beispielsweise als Durchgangsbohrung oder Sacklochbohrung ausgebildet. Durch die zweiteilige Ausbildung der Befestigungsvorrichtung kann der Abstand der zu verbindenden Leiterplatten in einfacher und flexibler Weise durch die Länge des Abstandselements vorgegeben werden. Hierzu kann beispielsweise aus mehreren gleichartigen Abstandselementen mit unterschiedlicher Länge je nach gewünschtem Abstand ein bestimmtes Abstandselement ausgewählt und mit dem Befestigungselement verbunden werden. Das Abstandselement ist separat von der ersten Leiterplatte ausgebildet, also nicht einteilig mit der ersten Leiterplatte. Das Abstandselement wird mit dem damit verbundenen Befestigungselement an einer ersten Leiterplatte befestigt. Anschließend kann eine zweite Leiterplatte mit dem Befestigungselement verrastet werden.

Eine Befestigungsvorrichtung nach Anspruch 13 gewährleistet in einfacher und zuverlässiger Weise eine Befestigung des Abstandselements an der ersten Leiterplatte. Das Metall ist beispielsweise Stahl oder Messing. Dadurch, dass das Abstandselement aus einem Metall besteht, bildet die Befestigungsvorrichtung ein SMD-Bauelement (SMD: Surface Mounted Device) aus, das beispielsweise zusammen mit weiteren SMD-Bauelementen an der ersten Leiterplatte verlötet wird.

Der Erfindung liegt ferner die Aufgabe zugrunde, ein Verfahren zu schaffen, das in einfacher, flexibler und automatisierter Weise ein beabstandetes Verbinden von Leiterplatten ermöglicht.

Diese Aufgabe wird durch ein Verfahren mit den Merkmalen des Anspruchs 14 gelöst. Die Vorteile des erfindungsgemäßen Verfahrens entsprechen den bereits beschriebenen Vorteilen des erfindungsgemäßen Befestigungselements und der erfindungsgemäßen Befestigungsvorrichtung. Das jeweilige Befestigungselement kann mit dem zugehörigen Abstandselement bevor oder nachdem das Abstandselement an der ersten Leiterplatte befestigt bzw. verlötet wurde, verbunden werden. Vorzugsweise wird das jeweilige Befestigungselement zunächst mit einem zugehörigen Abstandselement zu einer Befestigungsvorrichtung verbunden und anschließend das Abstandselement an der ersten Leiterplatte befestigt bzw. verlötet. Das erfindungsgemäße Verfahren kann insbesondere auch mit den Merkmalen der Ansprüche 12 und 13 weitergebildet werden.

Weitere Merkmale, Vorteile und Einzelheiten der Erfindung ergeben sich aus der nachfolgenden Beschreibung mehrerer Ausführungsbeispiele. Es zeigen:
- Fig. 1: einen Schnitt durch eine Befestigungsvorrichtung gemäß einem ersten Ausführungsbeispiel, die zwei Leiterplatten beabstandet miteinander verbindet,
- Fig. 2: eine perspektivische Ansicht der Befestigungsvorrichtung in Fig. 1,
- Fig. 3: eine perspektivische Ansicht eines Befestigungselements der Befestigungsvorrichtung in Fig. 2,
- Fg. 4: eine perspektivische Ansicht eines Abstandselements der Befestigungsvorrichtung in Fig. 2,
- Fig. 5: einen Schnitt durch eine Befestigungsvorrichtung gemäß einem zweiten Ausführungsbeispiel, die zwei Leiterplatten beabstandet miteinander verbindet, und
- Fig. 6: einen Schnitt durch eine Befestigungsvorrichtung gemäß einem dritten Ausführungsbeispiel, die zwei Leiterplatten beabstandet miteinander verbindet.

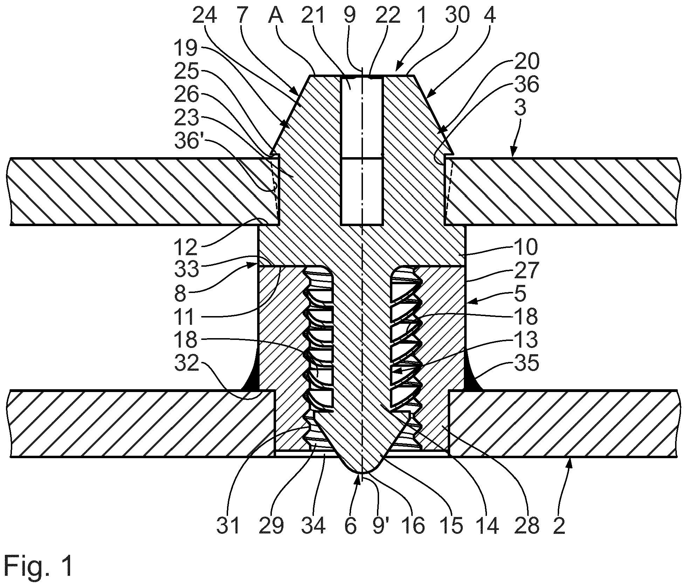

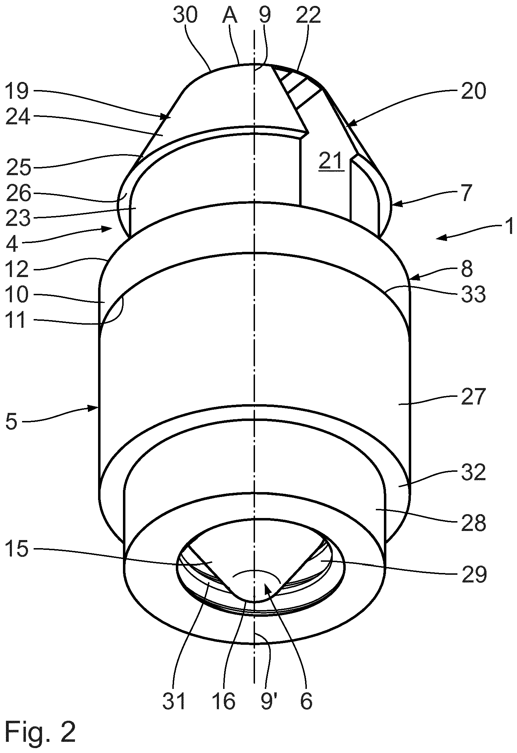

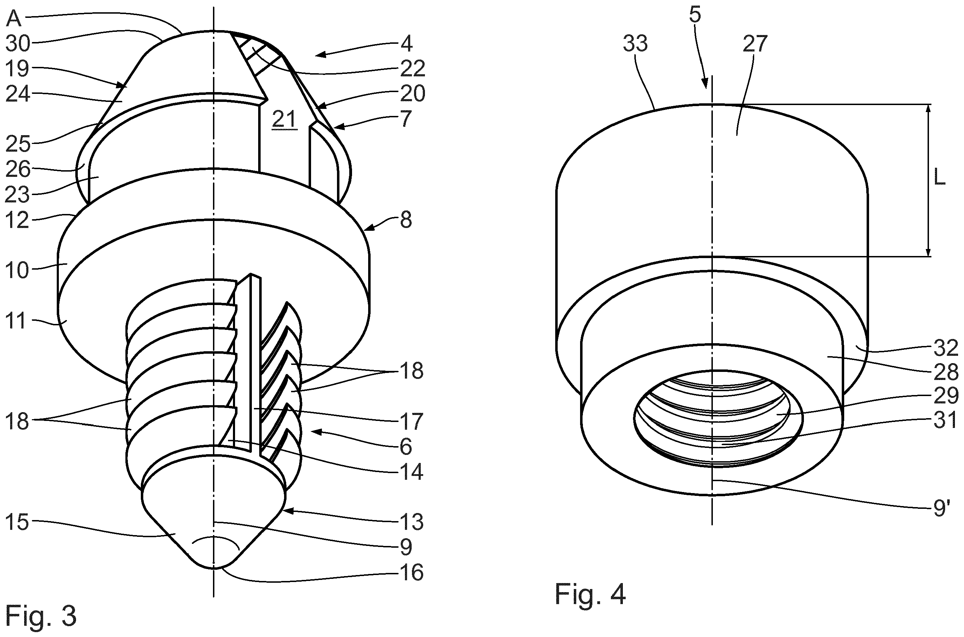

Nachfolgend ist anhand der Figuren 1 bis 4 ein erstes Ausführungsbeispiel beschrieben. Eine Befestigungsvorrichtung 1 dient zum beabstandeten Verbinden einer ersten Leiterplatte 2 mit einer zweiten Leiterplatte 3. Die Befestigungsvorrichtung 1 umfasst ein Befestigungselement 4, das mit einem zugehörigen Abstandselement 5 formschlüssig verbunden ist.

Das Befestigungselement 4 weist einen als ersten Rastabschnitt 6 ausgebildeten Befestigungsabschnitt und einen zweiten Rastabschnitt 7 auf, zwischen denen ein Mittelabschnitt 8 angeordnet ist. Die Rastabschnitte 6, 7 sind mit dem Mittelabschnitt 8 einteilig ausgebildet. Weiterhin sind die Rastabschnitte 6, 7 derart an dem Mittelabschnitt 8 angeordnet, dass das Befestigungselement 4 eine Mittellängsachse 9 aufweist.

Die Rastabschnitte 6, 7 und der Mittelabschnitt 8 sind aus einem Kunststoffmaterial ausgebildet, das bis zu einer Temperatur von mindestens 240°C, insbesondere von mindestens 260°C, und insbesondere von mindestens 280°C beständig ist. Das Kunststoffmaterial ist elektrisch isolierend. Beispielsweise ist das Kunststoffmaterial ein LCP-Kunststoff (LCP: Liquid Crystal Polymer).

Der Mittelabschnitt 8 ist durch eine kreisförmige Scheibe 10 gebildet, die an einer dem ersten Rastabschnitt 6 zugewandten Stirnseite einen ersten Anschlag 11 für das Abstandselement 5 und an einer dem zweiten Rastabschnitt 7 zugewandten Stirnseite einen zweiten Anschlag 12 für die zweite Leiterplatte 3 ausbildet. Der Mittelabschnitt 8 erstreckt sich im Wesentlichen senkrecht zu der Mittellängsachse 9.

Ausgehend von dem Mittelabschnitt 8 erstreckt sich ein Tragzapfen 13 konzentrisch zu der Mittellängsachse 9. Der Tragzapfen 13 weist einen zylinderförmigen Tragzapfen-Grundkörper 14 auf, an dem endseitig eine Tragzapfen-Spitze 15 angeordnet ist, so dass sich der Tragzapfen 13 in Richtung eines freien Endes 16 verjüngt. An dem Tragzapfen-Grundkörper 14 sind einander relativ zu der Mittellängsachse 9 gegenüberliegende Tragzapfen-Stege 17 angeordnet, die entlang der Mittellängsachse 9 verlaufen und die Tragzapfen-Spitze 15 mit dem Mittelabschnitt 8 verbinden. Zwischen den Tragzapfen-Stegen 17 sind auf beiden Seiten des Tragzapfen-Grundkörpers 14 mehrere erste Rastvorsprünge 18 angeordnet, die entlang der Mittellängsachse 9 beabstandet zueinander angeordnet sind. Die ersten Rastvorsprünge 18 sind lamellenartig bzw. tellerartig ausgebildet. Alternativ können die ersten Rastvorsprünge 18 gewindeartig ausgebildet sein. Die ersten Rastvorsprünge 18 erstrecken sich im Wesentlichen entlang des halben Umfangs des Tragzapfen-Grundkörpers 14. Der Tragzapfen 13 und die zugehörigen ersten Rastvorsprünge 18 bilden den ersten Rastabschnitt 6 aus.

Der zweite Rastabschnitt 7 erstreckt sich ausgehend von dem Mittelabschnitt 8 konzentrisch zu der Mittellängsachse 9. Der zweite Rastabschnitt 7 umfasst zwei Rastarme 19, 20, die beabstandet zueinander an dem Mittelabschnitt 8 angeordnet sind und zwischen sich einen schlitzförmigen Freiraum 21 begrenzen. Durch die beabstandete Anordnung sind die Rastarme 19, 20 endseitig in radialer Richtung flexibel verlagerbar. Die Rastarme 19, 20 sind endseitig durch eine den Freiraum 21 begrenzende Wand 22 verbunden. Die Wand 22 ist derart dünn ausgebildet, dass diese eine Solldeformationsstelle ausbildet, die eine Verlagerung der Rastarme 19, 20 in radialer Richtung zulässt. Vorzugsweise ist die Wand 22 derart dünn, dass diese eine Sollbruchstelle ausbildet, so dass die Wand 22 bei einer radialen Verlagerung der Rastarme 19, 20 zerstört wird.

An einem freien Ende 30 des zweiten Rastabschnitts 7 sind die Rastarme 19, 20 eben ausgebildet. Dadurch, dass die Wand 22 bündig zwischen den Rastarmen 19, 20 verläuft, bildet der zweite Rastabschnitt 7 endseitig eine ebene Montagefläche A aus. Die Montagefläche A verläuft im Wesentlichen senkrecht zu der Mittellängsachse 9. Die Montagefläche A ist insbesondere kreisförmig ausgebildet. Vorzugsweise gilt: A ≥ 3 mm², insbesondere A ≥ 4,5 mm², und insbesondere A ≥ 6 mm². Die Solldeformationsstelle bzw. Sollbruchstelle ist somit im Bereich der Montagefläche A ausgebildet.

Die Rastarme 19, 20 weisen jeweils einen Rastarm-Grundkörper 23 und eine daran angeordnete Rastarm-Spitze 24 auf. Der jeweilige Rastarm-Grundkörper 23 und die zugehörige Rastarm-Spitze 24 sind im Querschnitt in Form eines Kreissegments ausgebildet. Der jeweilige Rastarm-Grundkörper 23 weist entlang der Mittellängsachse 9 einen konstanten Radius auf, so dass der jeweilige Rastarm-Grundkörper 23 in Form eines im Wesentlichen halben Zylinders ausgebildet ist. Demgegenüber nimmt der Radius der jeweiligen Rastarm-Spitze 24 entlang der Mittellängsachse 9 zu dem freien Ende 30 hin ab, so dass sich der zweite Rastabschnitt 7 in Richtung der Montagefläche A verjüngt. Dadurch, dass die jeweilige Rastarm-Spitze 24 unmittelbar benachbart zu dem zugehörigen Rastarm-Grundkörper 23 einen größeren Radius hat, bildet die Rastarm-Spitze 24 mit dem zugehörigen Rastarm-Grundkörper 23 einen jeweiligen zweiten Rastvorsprung 25 aus. Der jeweilige zweite Rastvorsprung 25 bildet an einer dem Mittelabschnitt 8 zugewandten Stirnseite einen zugehörigen dritten Anschlag 26 aus. Der jeweilige Anschlag 26 hat die Form eines Ringabschnitts.

Das Abstandselement 5 weist einen Distanzabschnitt 27 und einen einteilig damit ausgebildeten Einführabschnitt 28 auf. Der Distanzabschnitt 27 und der Einführabschnitt 28 sind hohlzylinderförmig ausgebildet und begrenzen eine Rastausnehmung 29. Die Rastausnehmung 29 erstreckt sich entlang einer Mittellängsachse 9' durch das Abstandselement 5. An einer der Rastausnehmung 29 zugewandten Innenwand weist das Abstandselement 5 ein Innengewinde 31 zum Verrasten mit den ersten Rastvorsprüngen 18 auf. Der Distanzabschnitt 27 weist einen größeren Radius auf als der Einführabschnitt 28, so dass das Abstandselement 5 einen ringförmigen Einführanschlag 32 ausbildet. Darüber hinaus bildet der Distanzabschnitt 27 an einer dem Einführabschnitt 28 abgewandten Seite einen ringförmigen Anschlag 33 aus. Das Abstandselement 5 besteht zum Verlöten mit der ersten Leiterplatte 2 aus einem Metall, insbesondere aus Stahl oder Messing.

Nachfolgend ist das beabstandete Verbinden der Leiterplatten 2, 3 im Einzelnen beschrieben. Die Leiterplatten 2, 3 werden mittels mehrerer Befestigungsvorrichtungen 1 beabstandet miteinander verbunden. Nachfolgend ist beispielhaft lediglich das Verbinden der Leiterplatten 2, 3 mittels einer der Befestigungsvorrichtungen 1 beschrieben.

Zunächst wird aus dem Befestigungselement 4 und dem zugehörigen Abstandselement 5 die Befestigungsvorrichtung 1 hergestellt. Hierzu wird der erste Rastabschnitt 6 in die Rastausnehmung 29 eingeführt, wodurch die ersten Rastvorsprünge 18 in dem Innengewinde 31 verrasten. Durch die Tragzapfen-Spitze 15 wird das Einführen erleichtert. Das Einführen wird gestoppt, wenn die Anschläge 11 und 33 gegeneinander anliegen.

Das Abstandselement 5 wird als separates Bauteil bereitgestellt. Vorzugsweise stehen mehrere gleichartige Abstandselemente 5 mit einer unterschiedlichen Länge L bereit, so dass je nach gewünschtem Abstand zwischen den Leiterplatten 2, 3 ein Abstandselement 5 mit einer geeigneten Länge L auswählbar ist. Das Verrasten des Befestigungselements 4 mit dem zugehörigen Abstandselement 5 kann manuell oder automatisiert erfolgen. Ein automatisiertes Verrasten erfolgt beispielsweise derart, dass mehrere Befestigungselemente 4 gegurtet sind und zugehörige Abstandselemente 5 vollautomatisch bestückt werden. Weiterhin kann das automatisierte Verrasten beispielsweise derart erfolgen, dass das Befestigungselement 4 an der ebenen Montagefläche A pneumatisch gehalten wird und mittels eines geeigneten Handhabungssystems mit dem ersten Rastabschnitt 6 in die Rastausnehmung 29 eingeführt wird. Das Abstandselement 5 wird hierbei mittels des Handhabungssystems beispielsweise mechanisch gehalten.

Anschließend wird die erste Leiterplatte 2 an der Befestigungsvorrichtung 1 befestigt. Hierzu wird die Befestigungsvorrichtung 1 an der Montagefläche A pneumatisch gehalten und mittels eines Handhabungssystems der Einführabschnitt 28 des Abstandselements 5 in eine zugehörige Einführöffnung 34 in der ersten Leiterplatte 2 eingeführt. Das Einführen wird durch den Einführanschlag 32 gestoppt. Das metallische Abstandselement 5 wird daraufhin mit der ersten Leiterplatte 2 durch ein Lötmittel 35 entsprechend einem SMD-Bauelement (SMD: Surface Mounted Device) verlötet. Bei diesem Lötvorgang können ggf. auch noch weitere SMD-Bauelemente mit der ersten Leiterplatte 2 verlötet werden. Das Lötmittel 35 stellt eine feste Verbindung zwischen dem metallischen Abstandselement 5 und der ersten Leiterplatte 2 her. Dadurch, dass das Befestigungselement 4 aus einem hochtemperaturbeständigen Kunststoffmaterial ausgebildet ist, wird das Befestigungselement 4 aufgrund des Lötvorgangs nicht beschädigt.

Anschließend wird die zweite Leiterplatte 3 mit dem Befestigungselement 4 verbunden. Hierzu wird die zweite Leiterplatte 3 manuell oder automatisch gegriffen und derart in Richtung der Mittellängsachse 9 bewegt, dass der zweite Rastabschnitt 7 in eine durchgehende Ausnehmung 36 der zweiten Leiterplatte 3 eingeführt wird. Beim Einführen werden die Rastarme 19, 20 radial in Richtung der Mittellängsachse 9 verlagert, so dass die Wand 22 aufgrund der Ausbildung als Solldeformationsstelle bzw. Sollbruchstelle deformiert bzw. zerstört wird. Die Rastarm-Spitzen 24 können so in einfacher Weise durch die Ausnehmung 36 geführt werden. Die Bewegung der zweiten Leiterplatte 3 entlang der Mittellängsachse 9 wird gestoppt, wenn die zweite Leiterplatte 3 gegen den Anschlag 12 anschlägt. Die axiale Länge der Rastarm-Grundkörper 23 ist derart angepasst, dass beim Anschlagen die Rastarm-Spitzen 24 vollständig durch die Ausnehmung 36 geführt sind, so dass die dritten Anschläge 26 einen Gegenanschlag für die zweite Leiterplatte 3 bilden. Hierzu entspricht die axiale Länge der Rastarm-Grundkörper 23 ungefähr der Dicke der zweiten Leiterplatte 3. Nachdem die Rastarm-Spitzen 24 vollständig durch die Ausnehmung 36 geführt sind, verlagern sich die elastischen Rastarme 19, 20 wieder in radialer Richtung von der Mittellängsachse 9 weg. Der Radius der Rastarm-Grundkörper 23 entspricht im Wesentlichen dem Radius der Ausnehmung 36, so dass die zweite Leiterplatte 3 quer zu der Mittellängsachse 9 gegen die Rastarm-Grundkörper 23 anliegt und sicher gehalten wird. Der zweite Rastabschnitt 7 wird auf diese Weise in axialer und radialer Richtung sicher an der zweiten Leiterplatte 3 befestigt.

Ist die zweite Leiterplatte 3 derart ausgebildet, dass sich die Ausnehmung 36' in Richtung einer der ersten Leiterplatte 2 abgewandten Seite erweitert, so liegt die zweite Leiterplatte 3 gegen den Anschlag 12 an und ist in radialer Richtung gesichert. In axialer Richtung wird die zweite Leiterplatte 3 durch die Schwerkraft in Position gehalten. Diese alternative Ausgestaltung der zweiten Leiterplatte 3 und der Ausnehmung 36' ist in Fig. 1 als gestrichelte Linie dargestellt.

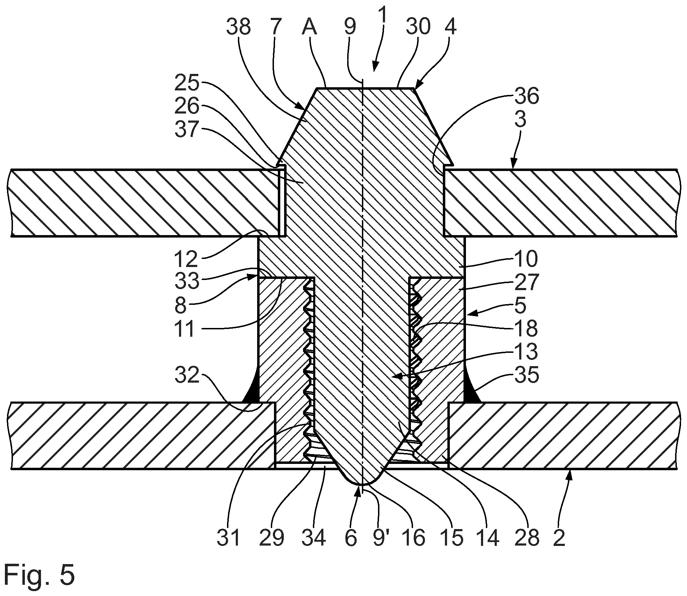

Nachfolgend ist anhand von Figur 5 ein zweites Ausführungsbeispiel beschrieben. Im Unterschied zu dem ersten Ausführungsbeispiel weist der zweite Rastabschnitt 7 einen zylinderförmigen Grundkörper 37 und eine im Querschnitt kreisförmige Spitze 38 auf. Die Spitze 38 bildet endseitig die ebene Montagefläche A aus. Weiterhin bildet die Spitze 38 einen zweiten Rastvorsprung 25 mit einem dritten Anschlag 26 aus. Das Befestigungselement 4 ist aus einem elastischen Material, insbesondere aus einem elastischen Kunststoff- oder Gummimaterial, so dass der zweite Rastabschnitt 7 durch die Ausnehmung 36 einführbar ist. Hinsichtlich des weiteren Aufbaus und der weiteren Funktionsweise wird auf das erste Ausführungsbeispiel verwiesen.

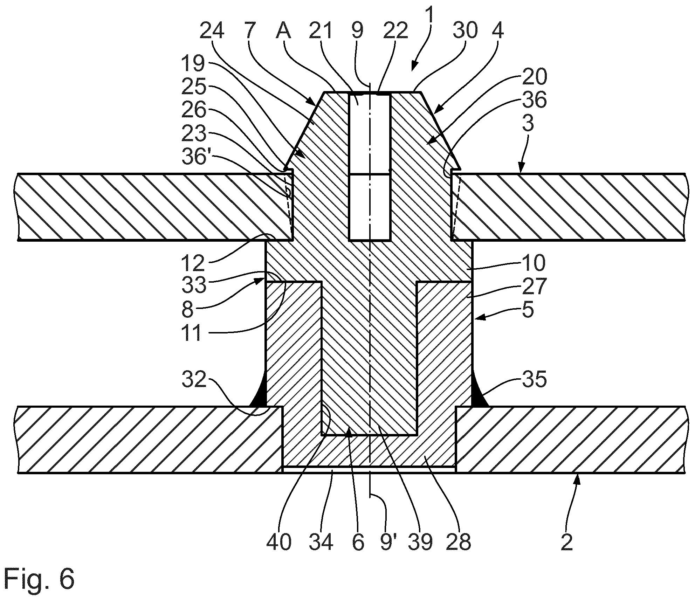

Nachfolgend ist anhand von Fig. 6 ein drittes Ausführungsbeispiel beschrieben. Im Unterschied zu den vorangegangenen Ausführungsbeispielen ist der Befestigungsabschnitt 6 mit dem Abstandselement 5 kraftschlüssig und/oder stoffschlüssig verbunden. Der Befestigungsabschnitt 6 weist hierzu einen Befestigungszapfen 39 auf, der mit dem Mittelabschnitt 8 verbunden ist. Der Befestigungszapfen 39 ist in einer Ausnehmung 40 des Abstandselements 5 angeordnet. Der Befestigungszapfen 39 kann sich entsprechend den vorangegangenen Ausführungsbeispielen zu seinem freien Ende 16 hin verjüngen. Alternativ kann der Befestigungszapfen 39 endseitig eben ausgebildet sein. Die Ausnehmung 40 kann als Durchgangsbohrung oder Sacklochbohrung ausgebildet sein. In Fig. 6 ist eine Ausbildung als Sacklochbohrung veranschaulicht. Der Befestigungszapfen 39 kann durch eine Presspassverbindung, eine Klebverbindung oder eine Spritzgussverbindung mit dem Abstandselement 5 verbunden sein. Im Falle einer Spritzgussverbindung dient das Abstandselement 5 als Einlegeteil für eine Spritzgussmaschine, wobei das Befestigungselement 4 durch Spritzgießen unmittelbar bei der Herstellung mit dem Abstandselement 5 verbunden wird. Hinsichtlich des weiteren Aufbaus und der weiteren Funktionsweise wird auf die vorangegangenen Ausführungsbeispiele verwiesen.

Die erfindungsgemäße Abstandsmontage von Leiterplatten 2, 3 gewährleistet somit eine hohe Prozesssicherheit und einen hohen Automatisierungsgrad beim Montieren von zwei Leiterplatten auf einen definierten Abstand.

Die Montagefläche stellt eine integrierte Ansaughilfe bereit und gewährleistet eine vollautomatische Bestückung der Befestigungsvorrichtung 1 auf der ersten Leiterplatte 2. Die integrierte Ansaughilfe muss im Nachgang nicht entfernt werden. Die Montagefläche ist mit einer Solldeformationsstelle bzw. Sollbruchstelle versehen, so dass nach dem Bestücken eine Snap-In-Funktion bzw. Rastfunktion des zweiten Rastabschnitts 7 gewährleistet ist. Durch das SMD-Bestücken auf der ersten Leiterplatte 2 und die Snap-In-Verbindung bzw. Rastverbindung mit der zweiten Leiterplatte 3 entfällt jegliches Verschrauben, wodurch die hohe Prozesssicherheit gewährleistet ist. Durch die Befestigungsvorrichtung 1 können somit Leiterplatten 2, 3 einfach, schnell, flexibel und zuverlässig miteinander beabstandet verbunden werden.

## Patentansprüche

1. Befestigungselement zur Befestigung an einer Leiterplatte mit
- einem ersten Befestigungsabschnitt (6) zum Verbinden mit einem Abstandselement (5),
- einem zweiten Rastabschnitt (7) zum Verrasten mit einer Leiterplatte (3), und
- einem Mittelabschnitt (8), der zur Ausbildung eines ersten Anschlags (11) für das Abstandselement (5) und eines zweiten Anschlags (12) für die Leiterplatte (3) zwischen dem Befestigungsabschnitt (6) und dem Rastabschnitt (7) angeordnet ist,
**dadurch gekennzeichnet,**
**dass** der zweite Rastabschnitt (7) endseitig eine als Ansaugfläche dienende Montagefläche (A) zum pneumatischen Halten des Befestigungselements (4) ausbildet.

2. Befestigungselement nach Anspruch 1, **dadurch gekennzeichnet, dass** die Montagefläche (A) eben ausgebildet ist und insbesondere senkrecht zu einer Mittellängsachse (9) des Befestigungselements (4) verläuft.

3. Befestigungselement nach Anspruch 1 oder 2, **dadurch gekennzeichnet, dass** der zweite Rastabschnitt (7) im Bereich der Montagefläche (A) eine Solldeformationsstelle, insbesondere eine Sollbruchstelle, aufweist.

4. Befestigungselement nach einem der Ansprüche 1 bis 3, **dadurch gekennzeichnet, dass** der zweite Rastabschnitt (7) mindestens zwei Rastarme (19, 20) aufweist, die zueinander beabstandet und endseitig durch eine Wand (22) verbunden sind, wobei die Wand (22) insbesondere eine Solldeformationsstelle ausbildet.

5. Befestigungselement nach einem der Ansprüche 1 bis 4, **dadurch gekennzeichnet, dass** der Befestigungsabschnitt (6) als erster Rastabschnitt ausgebildet ist, der einen konzentrisch zu einer Mittellängsachse (9) angeordneten Tragzapfen (13) aufweist, an dem mindestens ein erster Rastvorsprung (18) ausgebildet ist.

6. Befestigungselement nach Anspruch 5, **dadurch gekennzeichnet, dass** an dem Tragzapfen (13) entlang der Mittellängsachse (9) mehrere erste Rastvorsprünge (18) ausgebildet sind.

7. Befestigungselement nach einem der Ansprüche 1 bis 6, **dadurch gekennzeichnet, dass** sich der Befestigungsabschnitt (6) zu einem freien Ende (16) verjüngt.

8. Befestigungselement nach einem der Ansprüche 1 bis 7, **dadurch gekennzeichnet, dass** der zweite Rastabschnitt (7) mindestens einen zweiten Rastvorsprung (25) ausbildet und sich ausgehend von dem mindestens einen zweiten Rastvorsprung (25) in Richtung eines freien Endes verjüngt.

9. Befestigungselement nach einem der Ansprüche 1 bis 8, **dadurch gekennzeichnet, dass** der Befestigungsabschnitt (6), der Rastabschnitt (7) und der Mittelabschnitt (8) aus einem Kunststoffmaterial ausgebildet sind, das bis zu einer Temperatur von mindestens 240°C, insbesondere von mindestens 260°C, und insbesondere von mindestens 280°C beständig ist.

10. Befestigungselement nach einem der Ansprüche 1 bis 9, **dadurch gekennzeichnet, dass** der Befestigungsabschnitt (6), der Rastabschnitt (7) und der Mittelabschnitt (8) aus einem elektrisch isolierenden Kunststoffmaterial ausgebildet sind.

11. Befestigungselement nach einem der Ansprüche 1 bis 10, **dadurch gekennzeichnet, dass** der Befestigungsabschnitt (6), der Rastabschnitte (7) und der Mittelabschnitt (8) einteilig miteinander ausgebildet sind.

12. Befestigungsvorrichtung zum beabstandeten Verbinden von Leiterplatten mit
- einem Abstandselement (5) zur Befestigung an einer ersten Leiterplatte (2),
- einem Befestigungselement (4) nach einem der Ansprüche 1 bis 11 zur Befestigung an einer zweiten Leiterplatte (3), wobei der Befestigungsabschnitt (6) mit dem Abstandselement (5) verbunden ist.

13. Befestigungsvorrichtung nach Anspruch 12, **dadurch gekennzeichnet, dass** das Abstandselement (5) zum Verlöten mit der ersten Leiterplatte (2) aus einem Metall ist.

14. Verfahren zum beabstandeten Verbinden von Leiterplatten, mit folgenden Schritten:
- Bereitstellen einer ersten Leiterplatte (2) und einer mit dieser zu verbindenden zweiten Leiterplatte (3),
- Bereitstellen mehrerer Abstandselemente (5) und zugehöriger Befestigungselemente (4) nach einem der Ansprüche 1 bis 11, die miteinander verbunden sind,
- Befestigen der Abstandselemente (5) an der ersten Leiterplatte (2), insbesondere durch Verlöten der Abstandselemente (5) an der ersten Leiterplatte (2), und
- Anordnen der zweiten Leiterplatte (3) an den Befestigungselementen (4), insbesondere derart, dass die zweiten Rastabschnitte (7) mit der zweiten Leiterplatte (3) verrastet sind.

## Claims

1. Fitting element for fitting to a circuit board with
- a first fitting section (6) for connection with a spacer element (5),
- a second arresting section (7) for arresting with a circuit board (3), and
- a central section (8), arranged between the fitting section (6) and the arresting section (7) for forming a first stop (11) for the spacer element (5) and a second stop (12) for the circuit board (3),
**characterised in that**
an end of the second arresting section (7) forms an assembly area (A) serving as a suction area for pneumatically holding the fitting element (4).

2. Fitting element according to claim 1, **characterised in that** the assembly area (A) is designed flat, and in particular extends vertically to a central longitudinal axis (9) of the fitting element (4).

3. Fitting element according to claim 1 or 2, **characterised in that** the second arresting section (7) comprises a predetermined deformation point in the region of the assembly area (A), in particular a predetermined breaking point.

4. Fitting element according to one of the claims 1 to 3, **characterised in that** the second arresting section (7) comprises at least two arresting arms (19, 20), arranged at a distance from each other and connected by a wall (22) at their ends, wherein the wall (22) in particular forms a predetermined deformation point.

5. Fitting element according to one of the claims 1 to 4, **characterised in that** the fitting section (6) is designed as a first arresting section comprising a support pin (13), arranged concentrically to a central longitudinal axis (9), on which at least one first arresting projection (18) is formed.

6. Fitting element according to claim 5, **characterised in that** several first arresting projections (18) are formed on the support pin (13) along the central longitudinal axis (9).

7. Fitting element according to one of the claims 1 to 6, **characterised in that** the fitting section (6) narrows towards a free end (16).

8. Fitting element according to one of the claims 1 to 7, **characterised in that** the second arresting section (7) is designed with at least one second arresting projection (25) and narrows in the direction of a free end, starting from the at least one second arresting projection (25).

9. Fitting element according to one of the claims 1 to 8, **characterised in that** the fitting section (6), the arresting section (7) and the central section (8) are made from a plastic material that is resistant up to a temperature of at least 240°C, in particular of at least 260°C, and in particular of at least 280°C.

10. Fitting element according to one of the claims 1 to 9, **characterised in that** the fitting section (6), the arresting section (7) and the central section (8) are made from an electrically insulating plastic material.

11. Fitting element according to one of the claims 1 to 10, **characterised in that** the fitting section (6), the arresting section (7) and the central section (8) are designed together as a single piece.

12. Fitting device for the spaced connection of circuit boards, with
- a spacer element (5) for fitting to a first circuit board (2),
- a fitting element (4) according to one of the claims 1 to 11 for fitting to a second circuit board (3), wherein the fitting section (6) is connected with the spacer element (5).

13. Fitting device according to claim 12, **characterised in that** the spacer element (5) for soldering to the first circuit board (2) is made from a metal.

14. Method for the spaced connection of circuit boards, with the following steps:
- provision of a first circuit board (2) and a second circuit board (3) to be connected with the same,
- provision of several spacer elements (5) and associated fitting elements (4) according to one of the claims 1 to 11, which are connected with each other,
- fitting the spacer elements (5) to a first circuit board (2), in particular through soldering the spacer elements (5) to the first circuit board (2), and
- arranging the second circuit board (3) on the fitting elements (4), in particular in such a way that the second arresting sections (7) are arrested with the second circuit board (3).

## Revendications

1. Elément de fixation destiné à être fixé sur une carte de circuit imprimé, avec
- une première section de fixation (6) pour le raccordement à un élément d'espacement (5),
- une deuxième section d'enclenchement (7) pour l'enclenchement avec une carte de circuit imprimé (3), et
- une section centrale (8), disposée entre la section de fixation (6) et la section d'enclenchement (7) pour la formation d'une première butée (11) pour l'élément d'espacement (5) et d'une deuxième butée (12) pour la carte de circuit imprimé (3),
**caractérisé en ce**
**que** la deuxième section d'enclenchement (7) forme du côté de l'extrémité une surface de montage (A) servant de surface d'aspiration pour le maintien pneumatique de l'élément de fixation (4).

2. Elément de fixation selon la revendication 1, **caractérisé en ce que** la surface de montage (A) est plane et s'étend en particulier perpendiculairement à un axe central longitudinal (9) de l'élément de fixation (4).

3. Elément de fixation selon la revendication 1 ou 2, **caractérisé en ce que** la deuxième section d'enclenchement (7) présente un emplacement de déformation prédéterminé, en particulier un emplacement de cassure prédéterminé au niveau de la surface de montage (A).

4. Elément de fixation selon l'une des revendications 1 à 3, **caractérisé en ce que** la deuxième section d'enclenchement (7) comprend au moins deux bras d'enclenchement (19, 20) espacés l'un de l'autre et reliés du côté de l'extrémité par une paroi (22), la paroi (22) formant en particulier un emplacement de déformation prédéterminé.

5. Elément de fixation selon l'une des revendications 1 à 4, **caractérisé en ce que** la section de fixation (6) est prévue comme première section d'enclenchement présentant un tourillon de support (13) disposé concentriquement à un axe central longitudinal (9), sur lequel est formée au moins une première saillie d'enclenchement (18).

6. Elément de fixation selon la revendication 5, **caractérisé en ce que** plusieurs premières saillies d'enclenchement (18) sont formées sur le tourillon de support (13) le long de l'axe central longitudinal (9).

7. Elément de fixation selon l'une des revendications 1 à 6, **caractérisé en ce que** la section de fixation (6) s'amincit jusqu'à une extrémité libre (16).

8. Elément de fixation selon l'une des revendications 1 à 7, **caractérisé en ce que** la deuxième section d'enclenchement (7) forme au moins une deuxième saillie d'enclenchement (25) et s'amincit vers une extrémité libre à partir de ladite au moins une deuxième saillie d'enclenchement (25).

9. Elément de fixation selon l'une des revendications 1 à 8, **caractérisé en ce que** la section de fixation (6), la section d'enclenchement (7) et la section centrale (8) sont constituées d'une matière plastique résistante à une température d'au moins 240° C, en particulier d'au moins 260° C, et notamment d'au moins 280° C.

10. Elément de fixation selon l'une des revendications 1 à 9, **caractérisé en ce que** la section de fixation (6), la section d'enclenchement (7) et la section centrale (8) sont constituées d'une matière plastique électriquement isolante.

11. Elément de fixation selon l'une des revendications 1 à 10, **caractérisé en ce que** la section de fixation (6), la section d'enclenchement (7) et la section centrale (8) sont réalisées d'un seul tenant.

12. Dispositif de fixation pour la connexion à espacement de cartes de circuit imprimé, avec
- un élément d'espacement (5) pour la fixation à une première carte de circuit imprimé (2),
- un élément de fixation (4) selon l'une des revendications 1 à 11 pour la fixation à une deuxième carte de circuit imprimé (3), dans lequel la section de fixation (6) est raccordée à l'élément d'espacement (5).

13. Dispositif de fixation selon la revendication 12, **caractérisé en ce que** l'élément d'espacement (5) est en métal pour brasage avec la première carte de circuit imprimé (2).

14. Procédé de connexion à espacement de cartes de circuit imprimé, comprenant les étapes suivantes :
- préparation d'une première carte de circuit imprimé (2) et d'une deuxième carte de circuit imprimé (3) à connecter à celle-ci,
- préparation de plusieurs éléments d'espacement (5) et d'éléments de fixation (4) correspondants selon l'une des revendications 1 à 11, lesquels sont raccordés les uns aux autres,
- fixation des éléments d'espacement (5) sur la première carte de circuit imprimé (2), en particulier par brasage des éléments d'espacement (5) sur la première carte de circuit imprimé (2), et
- disposition de la deuxième carte de circuit imprimé (3) sur les éléments de fixation (4), en particulier de manière à enclencher les deuxièmes sections d'enclenchement (7) avec la deuxième carte de circuit imprimé (3).
